# EUROPEAN PATENT SPECIFICATION

(11) **EP 3 087 614 B1**
(45) Date of publication and mention of the grant of the patent: **17.02.2021**
(21) Application number: 14875695.0
(22) Date of filing: 16.12.2014
(51) Int. Cl.: H01L 29/786, G02F 1/1368, G09F 9/30, H01L 29/66, H01L 29/861, H01L 27/32

(54) **P-TYPE OXIDE SEMICONDUCTOR, COMPOSITION FOR PRODUCING P-TYPE OXIDE SEMICONDUCTOR, METHOD FOR PRODUCING P-TYPE OXIDE SEMICONDUCTOR, SEMICONDUCTOR ELEMENT, DISPLAY ELEMENT, IMAGE DISPLAY DEVICE, AND SYSTEM**
P-TYP-OXIDHALBLEITER, ZUSAMMENSETZUNG ZUR HERSTELLUNG DES P-TYP-OXIDHALBLEITERS, VERFAHREN ZUR HERSTELLUNG DES P-TYP-OXIDHALBLEITERS, HALBLEITERELEMENT, ANZEIGEELEMENT, BILDANZEIGEVORRICHTUNG UND SYSTEM
SEMICONDUCTEUR D'OXYDE DE TYPE P, COMPOSITION POUR LA PRODUCTION D'UN SEMICONDUCTEUR D'OXYDE DE TYPE P, PROCÉDÉ DE PRODUCTION D'UN SEMICONDUCTEUR D'OXYDE DE TYPE P, ÉLÉMENT À SEMICONDUCTEURS, ÉLÉMENT D'AFFICHAGE, DISPOSITIF D'AFFICHAGE D'IMAGE ET SYSTÈME CORRESPONDANT

(30) Priority: 26.12.2013 JP 2013268915; 17.10.2014 JP 2014212632
(43) Date of publication of application: 02.11.2016
(73) Proprietor: Ricoh Company, Ltd., Tokyo 143-8555 (JP)
(72) Inventor: ABE, Yukiko, Tokyo 143-8555 (JP); UEDA, Naoyuki, Tokyo 143-8555 (JP); NAKAMURA, Yuki, Tokyo 143-8555 (JP); MATSUMOTO, Shinji, Tokyo 143-8555 (JP); SONE, Yuji, Tokyo 143-8555 (JP); SAOTOME, Ryoichi, Tokyo 143-8555 (JP); ARAE, Sadanori, Tokyo 143-8555 (JP)
(74) Representative: SSM Sandmair
(86) International application number: PCT/JP2014/083814
(87) International publication number: WO 2015/098785

(56) References cited:
- WO-A1-2013/035843
- WO-A1-2013/187486
- JP-A- 2013 138 165
- JP-A- 2013 138 165
- US-A1- 2010 032 668
- US-A1- 2010 270 609
- US-A1- 2012 037 998

## Description

### Technical Field

The present invention relates to a p-type oxide semiconductor, a composition for producing a p-type oxide semiconductor, a method for producing a p-type oxide semiconductor, a semiconductor element, a display element, an image display device, and a system.

### Background Art

After an announcement of InGaZnO₄ (a-IGZO) thin film transistor (TFT), which has higher mobility than a-Si in an amorphous state, researches and developments for making oxide semiconductors practicable have been actively conducted world wide. However, most of these oxide semiconductors are n-type using electrons as a carrier.

If a p-type oxide semiconductor, which is a good match for the n-type oxide semiconductor, can be used, a diode, an optical sensor, a solar cell, LED, or a bipolar transistor can be realized by forming a p-n junction by combining the p-type oxide semiconductor and the n-type oxide semiconductor. A band-gap of the oxide semiconductos can be widen, and therefore it is possible to make these devices transparent.

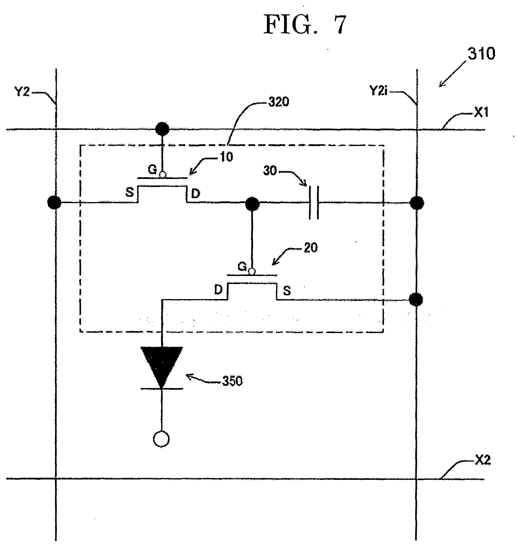

In an active matrix organic EL display, a 2T1C circuit as illustrated in FIG. 7 is used as a basic driving circuit. In this case, so-called source follower connection is established, if the driving transistor 20 is n-type. Thus, a time-dependent change (especially voltage rise) of organic EL device properties causes an operating point of the driving transistor to move to another operating point at different gate voltage, which shortens a half-life of the display. This problem will not be caused if a p-type transistor is used in a driving transistor.

Moreover, since the organic EL is driven by electric currents, a dispersion of current values leads to unevenness of display. Therefore, in the case where the threshold voltage of the transistor is dispersed, or changes over time, it is necessary to compensate to thereby prevent a display failure. When a circuit for compensate this is composed, the circuit becomes complicated, if it is composed only of an n-type transistor. A simpler circuit structure can be achieved by using both an n-type transistor and a p-type transistor.

From the reasons mentioned above, there is a need for a high performance p-type oxide semiconductor.

An active layer of a p-type oxide TFT, actual operation of which has been confirmed, is limited to an active layer containing monovalent copper (Cu), and an active layer containing divalent tin (Sn).

A Cu₂O crystal, which is a monovalent copper oxide, has a dumbbell structure of O-Cu-O as a basic structure, and forms a valence band peak with a hybrid orbital between a 3d orbital of Cu and a 2p orbital of oxygen. Holes are introduced into the valence band by oxygen excess nonstoichiometry, to thereby realize p-type conduction. In a delafossite-type crystal represented by CuMO₂ (M=Al, Ga, In) and a SrCu₂O₂-type crystal, it has been known that the aforementioned dumbbell structure is also a basic unit, and Cu is in a monovalent state.

In order for the aforementioned Cu-containing oxides to exhibit p-type electrical conductivity, it is necessary that the oxide has high crystallinity and a single phase of the oxide containing Cu⁺. In reality, however, it is difficult to specifically control a valence of Cu and an oxygen content, and a film tends to be a film in which crystal phases containing Cu⁺ and Cu²⁺ are mixed. Therefore, in the case where any of these p-type oxide materials is used in an active layer of a semiconductor element, it is difficult to optimize properties, such as carrier density, and carrier mobility.

NPL 1 and NPL 2 each disclose a TFT using a Cu₂O crystal as an active layer. Since properties of the active layer cannot be controlled sufficiently, a mobility of the TFT and an on-off ratio thereof have not reached to a level suitable for practical use. Moreover, PTL 1 discloses a TFT using a p-type material of a delafossite crystal containing monovalent Cu or Ag in an active layer. However, information, such as properties of the material of the active layer, formation method thereof, and properties of the transistor, is not disclosed sufficiently.

It has been known that p-type conductivity is attained with tin oxide, when Sn is a divalent state, i.e., SnO. However, tin oxide tends to be n-type SnO₂, as Sn is more stable in a state of Sn⁴⁺ where two 5p electrons and two 5s electrons are lost, than a state of Sn²⁺ where two 5p electron in the outermost shell are lost. When tin oxide is used for a p-type active layer, therefore, it is a challenge to realize a Sn²⁺ state, and stably maintaining this state.

PTL 2 discloses a p-type TFT using SnO as an active layer. Due to the aforementioned problem, the properties thereof and operation stability have not reached to a level suitable for practical use.

Specifically, in the aforementioned disclosures, properties of a p-type oxide material, which is an active layer, are not sufficiently controlled. As a result, a semiconductor element having desired properties has not been realized.

PTL 3 discloses, as a p-type semiconductor, an oxide containing at least two selected from the group consisting of Ag (ionic valency: 1), Cu (ionic valency: 1), Au (ionic valency: 1), Tl (ionic valency: 1), Pb (ionic valency: 2), Bi (ionic valency: 3), In (ionic valency: 1), Sn (ionic valency: 2), and Sb (ionic valency: 3). It is necessary to dope with holes to realize p-type conductivity, but there is no description regarding hole doping of an oxide containing Tl (ionic valency: 1), and therefore p-type conductivity has not been realized.

Accordingly, there is currently a need for a p-type oxide semiconductor, which has conductivity properties that can be used as an active layer of a semiconductor element.

### Citation List

### Patent Literature

PTL 1: Japanese Patent Application Laid-Open (JP-A) No. 2005-183984
PTL 2: JP-A No. 2010-212285
PTL 3: JP-A No. 10-284743

### Non-patent Literature

NPL 1: E. Fortunato, 8 others, Thin-film transistors based on p-type Cu₂O thin films produced at room temperature, Applied Physics Letters, VOL. 96, 2010, pp. 192102
NPL 2: K. Matsuzaki, 5 others, Epitaxial growth of high mobility Cu₂O thin films and application to p-channel thin film transistor, Applied Physics Letters, VOL. 93, 2008, pp. 202107

### Summary of Invention

### Technical Problem

The present invention aims to solve the aforementioned various problems in the art and to achieve the following object. Specifically, an object of the present invention is to provide a p-type oxide semiconductor, which has conductivity properties usable as an active layer of a semiconductor element.

### Solution to Problem

The means for solving the aforementioned problems are defined in claim 1.

### Advantageous Effects of Invention

The present invention can solve the aforementioned various problems in the art, and can provide a p-type oxide semiconductor, which has conductivity properties usable as an active layer of a semiconductor element.

### Brief Description of Drawings

FIG. 1 is a schematic diagram illustrating one example of a diode.
FIG. 2 is a schematic diagram illustrating one example of a top contact/ bottom gate field-effect transistor.
FIG. 3 is a schematic diagram illustrating one example of a bottom contact/ bottom gate field-effect transistor.
FIG. 4 is a schematic diagram illustrating one example of a top contact/ top gate field-effect transistor.
FIG. 5 is a schematic diagram illustrating one example of a bottom contact/ top gate field-effect transistor.
FIG. 6 is a diagram for explaining an image display element.
FIG. 7 is a diagram for illustrating one example of the display element of the present invention.
FIG. 8 is a schematic diagram illustrating one example of a positional relationship between an organic EL element and a field-effect transistor in a display element.
FIG. 9 is a schematic diagram illustrating another example of a positional relationship between an organic EL element and a field-effect transistor in a display element.
FIG. 10 is a schematic diagram illustrating one example of an organic EL element.
FIG. 11 is a diagram for explaining a display control device.
FIG. 12 is a diagram for explaining a liquid crystal display.
FIG. 13 is a diagram for explaining the display element of FIG. 12.

### Description of Embodiments

(P-Type Oxide Semiconductor, Composition for Producing P-Type Oxide Semiconductor, and Method for Producing P-Type Oxide Semiconductor)

### <P-Type Oxide Semiconductor>

The p-type oxide semiconductor of the present invention contains a metal oxide containing thallium (Tl), where the metal oxide has been hole doped.

In order to exhibit useful p-type conductivity properties, it is necessary that holes are present in an oxide semiconductor with a sufficient density, and the oxide semiconductor has a band structure in which holes easily move. The hole density of the p-type oxide semiconductor of the present invention is controlled by hole doping, and high mobility is realized since the oxide contains Tl. The hole density is preferably controlled in the range of 10¹⁰/cm³ to 10²¹/cm³, more preferably 10¹²/cm³ to 10¹⁹/cm³, by hole doping. When the hole density is within the aforementioned range, resistivity and conductivity properties useful as a semiconductor can be realized.

One of methods for performing the hole doping on the metal oxide is to realize oxygen excess (or, cation-deficient) nonstoichiometry. To this end, it is effective to control the conditions when the p-type oxide semiconductor is produced. In the case where the p-type oxide semiconductor is produced through vacuum film formation, holes can be generated, for example, by optimizing formulation of raw materials, and an atmosphere during the film formation. In the case where the p-type oxide semiconductor is produced through coating, holes can be generated, for example, by optimizing formulation of raw materials, and temperature, duration, and atmosphere during the baking process.

It is difficult to control a hole density of a conventional crystalline p-type oxide containing Cu⁺, as Cu is unintentionally oxidized and becomes divalent when it is attempted to create an oxygen excess state to increase the hole density. In the p-type oxide semiconductor of the present invention, on the other hand, Tl does not change to divalent even when oxygen is added excessively in a state containing Tl⁺ (a state where one 6p electron is lost). A valence modification is caused only when oxidation is progressed until trivalent (a state where one 6p electron and two 6s electrons are lost). Specifically, Tl⁺ hardly causes a valence modification compared to Cu⁺, and therefore it is possible to control the hole density in a wide range.

Considering use as an active layer in a semiconductor element, conductivity properties required are typically different depending on a type or properties of a semiconductor element. In the p-type oxide semiconductor of the present invention, a hole density can be controlled in a wide range. Therefore, required conductivity properties can be easily realized, which leads to improvement of performance of the semiconductor element.

Another method of the hole doping is substitutional doping. Part of cations in the metal oxide is substituted with cations having smaller ionic valency, to thereby generate holes depending on a difference in the valency. In the p-type oxide semiconductor of the present invention, however, Tl is in a +1 valent state. In this case, Tl⁺ cannot be substituted with cation having smaller valency. In the case where hole doping is performed by substitutional doping, a preferable embodiment is that the p-type oxide semiconductor contains another cation in addition to Tl, and substitutional doping is performed on that cation.

Moreover, hole doping can be performed by substituting part of oxygen sites in the metal oxide with anions having smaller ionic valency (i.e., the ionic valency is -3 or smaller). For example, it is effective that part of the oxygen sites is substituted with nitrogen.

In order to achieve high mobility, it is necessary that a valence band peak is delocalized. Specifically, it is preferred that the valence band peak be mainly composed of the 6s orbital of Tl. Other than the +1 valent state, Tl can be in a +3 valent state where one 6p electron and two 6s electrons are lost. In view of improving p-type conductivity properties, all Tl present in the p-type oxide semiconductor is preferably in the +1 valent state, rather than a state where +1 valent and +3 valent states are mixed.

In a conventional p-type oxide containing Sn²⁺, Sn tends to change into a more stable Sn⁴⁺ state, and therefore p-type conductivity properties thereof are not stable. In the p-type oxide semiconductor of the present invention, on the other hand, Tl is stably present in a monovalent state, and therefore conductivity properties thereof become more stable. The stable conductivity properties thereof lead to stable operation of a semiconductor element using the p-type oxide semiconductor as an active layer.

In a conventional p-type oxide containing Cu⁺, a valence band peak is composed of a hybrid orbital of a 3d orbital of Cu and a 2p orbital of O, and therefore anisotropy of the electron orbital thereof is strong. In the p-type oxide semiconductor of the present invention, on the other hand, carriers travel through a band composed of an isotropic 6s orbital of Tl⁺, and therefore conductivity properties are not influenced by crystallinity.

The p-type oxide semiconductor of the present invention may be amorphous. Alternatively, part of, or the entire p-type oxide semiconductor may be crystalline. As described earlier, the valence band peak is composed of an isotropic 6s orbital of Tl⁺, and therefore conductivity properties are not influenced by crystallinity.

The p-type oxide semiconductor of the present invention may contain an element other than Tl and O. For example, the p-type oxide semiconductor may be a composite oxide containing one or more metal elements other than Tl. In this case, the metal element other than Tl is preferably an element that is stably present with a certain valency. As described above, all of Tl is preferably in the +1 valent state. If the metal element other than Tl can create several valency states, a +1 valent state and a +3 valent state of Tl may be present together. Specific examples of elements that would create a state of several valences include transition metal elements. It is preferred that the p-type oxide semiconductor do not contain these elements. This is because p-type conductivity would be disturbed when a d-band formed with d electrons of the transition metal element affects a band formed of 6s orbital of Tl⁺. In view of the above, it is preferred that the p-type oxide semiconductor do not contain a transition metal element, such as Fe and Cu.

The p-type oxide semiconductor preferably contains at least one selected from the group consisting of magnesium (Mg), calcium (Ca), strontium (Sr), barium (Ba), zinc (Zn), cadmium (Cd), boron (B), aluminum (Al), gallium (Ga), silicon (Si), germanium (Ge), and tellurium (Te). Additionally or alternatively, the p-type oxide semiconductor preferably contains at least one selected from the group consisting of tin (Sn), antimony (Sb), lead (Pb), and bismuth (Bi). The state density of the band, and conductivity properties are controlled in wide ranges by adjusting a type and amount of a counter cation to Tl.

Among them, the metal oxide preferably contains aluminum (Al), or gallium (Ga), or both. It has been known that TlAlO₂ and TlGaO₂ each have a TlFeO₂ crystal structure, as they are crystallized. In the p-type oxide semiconductor of the present invention, one of the preferred embodiments is that the metal oxide has this crystal structure.

The amount by mole of thallium (Tl) contained in the metal oxide is preferably substantially equal to a total amount by mole of aluminum (Al) and gallium (Ga) contained in the metal oxide. As a result of this, a TlFeO₂ crystal structure is easily realized. In the present specification, the phrase "substantially equal" means, for example, that a molar ratio X:Y, where the amount by mole of Tl is X and the total amount by mole of Al and Ga is Y, is in the range of 1.0:0.9 to 1.0:1.1.

As described earlier, substitutional doping is one of the methods of the hole doping. In this case, the p-type oxide semiconductor contains a cation other than Tl, and this cation is substituted with a cation having a smaller valency. In order to generate holes through substitutional doping, it is necessary that local structure is maintained. If local structural change occurs when it is doped, the dopant may be settled in a stable local structure and does not generate carriers. Accordingly, substitutional doping is effective for the metal oxide having high crystallinity, or the metal oxide containing at least a short-distance or intermediate-distance rigid structure. Specifically, the oxide containing Tl, Al, and Ga, which has a TlFeO₂ crystal structure is an embodiment suitable for controlling a hole density through substitutional doping. For example, it is preferred that part of sites of Al or Ga be substituted with Mg or Zn.

A shape of the p-type oxide semiconductor is appropriately selected depending on the intended purpose without any limitation, and examples thereof include a film, and bulks (particles).

The p-type oxide semiconductor is useful as a p-type active layer of a semiconductor element, such as a p-n junction diode, a PIN photodiode, a field-effect transistor, light emitting element, and photoelectric conversion element.

As for the method for producing the p-type oxide semiconductor of the present invention, the method using the composition of the present invention described below is preferred.

Other methods for producing the p-type oxide semiconductor are appropriately selected depending on the intended purpose without any limitation, and examples thereof include sputtering, pulse laser deposition (PLD), CVD, and ALD.

### <Composition for Producing P-Type Oxide Semiconductor>

The composition for producing a p-type oxide semiconductor, according to the present invention, contains at least a solvent, and a Tl-containing compound, and may further contain other components according to the necessity.

The composition for producing p-type oxide semiconductor is a composition used for production of the p-type oxide semiconductor of the present invention.

### -Solvent-

The solvent is appropriately selected depending on the intended purpose without any limitation, and examples thereof include toluene, xylene, 2-ethyl hexanoic acid, acetyl acetone, ethylene glycol, and 2-methoxy ethanol.

In order to provide desired properties (e.g., viscosity, and dielectric constant) to the composition for producing p-type oxide semiconductor, a solvent, such as diethylene glycol, and dimethyl formamide, may also be used.

These may be used alone, or in combination.

An amount of the solvent in the composition for producing a p-type oxide semiconductor is appropriately selected depending on the intended purpose without any limitation.

### -Tl-Containing Compound-

The Tl-containing compound is appropriately selected depending on the intended purpose without any limitation, and examples thereof include: organic thallium carboxylates, such as thallium (I) formate, thallium (I) acetate, thallium (I) malonate, and thallium (I) 2-ethylhexanoate; inorganic salts, such as thallium (I) nitrate, and thallium (I) chloride; an organic thallium complexes; and thallium alkoxides, such as thallium ethoxide.

In the case where the composition for producing a p-type oxide semiconductor is to be produced with a nonpolar solvent, organic thallium carboxylate is preferable among them, and thallium (I) 2-ethylhexanoate is more preferable, in view of solubility. In the case where the composition for producing a p-type oxide semiconductor is to be produced with a polar solvent, an inorganic salt is preferable, and thallium (I) nitrate is more preferable, in view of solubility. Even when thallium is in a trivalent state in a raw material, it can be converted into monovalent thallium during baking, or by a heat treatment performed after baking. Therefore, use of thallium (III) nitrate or thallium (III) chloride is also preferable.

An amount of the Tl-containing compound in the composition for producing a p-type oxide semiconductor is appropriately selected depending on the intended purpose without any limitation.

The composition for producing a p-type oxide semiconductor preferably further contains a compound, which contains at least one selected from the group consisting of magnesium (Mg), calcium (Ca), strontium (Sr), barium (Ba), zinc (Zn), cadmium (Cd), boron (B), aluminum (Al), gallium (Ga), silicon (Si), germanium (Ge), and tellurium (Te).

Additionally or alternatively, the composition for producing a p-type oxide semiconductor preferably contains a compound, which contains at least one selected from the group consisting of tin (Sn), antimony (Sb), lead (Pb), and bismuth (Bi).

### <Method for Producing P-Type Oxide Semiconductor>

The method for producing p-type oxide semiconductor, according to the present invention, contains a coating step, and a heat treatment step, and may further contain other steps according to the necessity.

### -Coating Step-

The coating step is appropriately selected depending on the intended purpose without any limitation, provided that it contains applying a composition onto a support.

The composition is the composition for producing a p-type oxide semiconductor of the present invention.

The support is appropriately selected depending on the intended purpose without any limitation, and examples thereof include a glass substrate.

The application method is appropriately selected depending on the intended purpose without any limitation. For example, a known method, such as spin coating, inkjet printing, slit coating, nozzle printing, gravure printing, and micro-contact printing, can be used. In the case where a film of a uniform thickness is simply produced over a large area, spin coating is preferable. The film of a desired shape can be printed by using an appropriate printing method, such as inkjet printing, and micro contact printing, under appropriate printing conditions, and patterning in a later step is not necessary in those cases.

### -Heat Treatment Step-

The heat treatment step contains performing a heat treatment after the coating step.

The heat treatment step is appropriately selected depending on the intended purpose without any limitation, provided that it is a step capable of drying the solvent in the composition, decomposing the Tl-containing compound, and generating the p-type oxide semiconductor.

In the heat treatment step, drying of the solvent (referred as a "drying treatment" hereinafter), and decomposition of the Tl-containing compound and generation of the p-type oxide semiconductor (referred as a "decomposition and generation treatment" hereinafter) are preferably performed respectively at different temperature. Specifically, it is preferred that, after performing the drying of the solvent, the temperature be elevated to perform the decomposition of the Tl-containing compound, and the generation of the p-type oxide semiconductor.

The temperature of the drying treatment is not particularly limited, and is appropriately selected depending on the solvent contained. For example, the temperature thereof is 80°C to 180°C. It is also effective to use a vacuum oven in the drying process to reduce the temperature.

The duration of the drying treatment is appropriately selected depending on the intended purpose without any limitation. For example, the duration thereof is 10 minutes to 2 hours.

The temperature of the decomposition and generation treatment is appropriately selected depending on the intended purpose without any limitation. For example, the temperature thereof is 200°C to 400°C.

The duration of the decomposition and generation treatment is appropriately selected depending on the intended purpose without any limitation. For example, the duration thereof is 1 hour to 5 hours.

Note that, all of the aforementioned processes may be performed concurrently in the heat treatment step, or the aforementioned processes may be divided into several stages in the heat treatment step.

A method of the heat treatment step is appropriately selected depending on the intended purpose without any limitation, and examples thereof include a method of heating the support.

The atmosphere of the heat treatment step is appropriately selected depending on the intended purpose without any limitation.

In the heat treatment step, it is effective to irradiate the composition after the drying treatment with ultraviolet rays having a wavelength of 400 nm or shorter, to accelerate a reaction of the decomposition and generation treatment. By applying the ultraviolet rays having a wavelength of 400 nm or shorter, bond cleavage occurs in chemical bonds of organic materials, and the organic materials are decomposed, and thus the p-type oxide semiconductor can be efficiently produced.

The ultraviolet rays having a wavelength of 400 nm or shorter are appropriately selected depending on the intended purpose without any limitation, and examples thereof include ultraviolet rays having a wavelength of 222 nm, emitted from an excimer lamp.

Moreover, it is also preferable to apply ozone, instead of, or in combination with the radiation of the ultraviolet rays. Generation of oxide is accelerated by applying the ozone to the composition, after the drying treatment.

In the method for producing a p-type oxide semiconductor according to the present invention, the p-type oxide semiconductor is produced through a coating process. Compared to a production through a vacuum process, the p-type oxide semiconductor can be produced easily, with a large quantity, and at low cost.

Moreover, the method for producing a p-type oxide semiconductor can produce the p-type oxide semiconductor having excellent p-type conductivity. The conductivity properties largely depend on a constituent of the p-type oxide semiconductor (specifically, a Tl content, a type of metal elements other than Tl, and amounts thereof). In order to change the constituent of the p-type oxide semiconductor, an abundance ratio of the Tl-containing compound in the composition, or a blending ratio of the Tl-containing compound and another metal-containing compound should be changed. Moreover, one of methods of hole doping is to realize oxygen excess nonstoichiometry. The difference from stoichiometry of O can be controlled by varying various conditions, such as temperature, duration, and atmosphere of the heat treatment step. In the case where substitutional doping is performed on the cation sites, a compound containing a metal to be added by the substitutional doping is blended at the predetermined ratio when the composition is prepared. In the manner as described above, hole doping is easily realized, and conductivity properties are controlled. As a result, an oxide semiconductor having desired p-type conductivity is attained.

### (Semiconductor Element)

The semiconductor element of the present invention contains at least an active layer, and may further contain other members according to the necessity.

### <Active Layer>

The active layer is appropriately selected depending on the intended purpose without any limitation, provided that the active layer contains the p-type oxide semiconductor of the present invention.

Since the p-type oxide semiconductor of the present invention has excellent stability, and conduction properties of which are easily controlled depending on the intended purpose, as described above, the p-type oxide semiconductor of the present invention is suitable for use as an active layer of the semiconductor element. Specifically, properties of the semiconductor element can be improved by adding the p-type oxide semiconductor whose properties are optimized to the active layer.

A structure, shape, and size of the active layer are appropriately selected depending on the intended purpose without any limitation.

Examples of the semiconductor element include a diode, a field-effect transistor, a light emitting element, and a photoelectric conversion element.

### <Diode>

A type of the diode is appropriately selected depending on the intended purpose without any limitation, and examples thereof include a diode, which contains a first electrode, a second electrode, and the active layer formed between the first electrode and the second electrode. Examples of such a diode include a p-n junction diode, and a PIN photodiode.

### -P-N Junction Diode-

The p-n junction diode contains at least the active layer, and may further contain other members, such as an anode (positive electrode), and a cathode (negative electrode), according to the necessity.

### --Active Layer--

The active layer contains at least a p-type semiconductor layer, and an n-type semiconductor layer, and may further contain other members according to the necessity.

The p-type semiconductor layer and the n-type semiconductor layer are in contact with each other.

### ---P-Type Semiconductor Layer---

A material of the p-type semiconductor layer is appropriately selected depending on the intended purpose without any limitation, provided that it contains the p-type oxide semiconductor of the present invention.

It is preferred that a constituent or formation conditions of the p-type oxide semiconductor be selected to attain a carrier density and carrier mobility required for functioning as the active layer.

The average thickness of the p-type semiconductor layer is appropriately selected depending on the intended purpose without any limitation, but the average thickness thereof is preferably 50 nm to 2,000 nm.

### ---N-Type Semiconductor Layer---

A material of the n-type semiconductor layer is appropriately selected depending on the intended purpose without any limitation, but the material thereof is preferably an n-type transparent oxide semiconductor.

The n-type oxide semiconductor is appropriately selected depending on the intended purpose without any limitation, and examples thereof include ZnO, and IGZO (In-Ga-Zn-O).

A formation method of the n-type semiconductor layer is appropriately selected depending on the intended purpose without any limitation, and examples thereof include: a vacuum process, such as sputtering, pulse laser deposition (PLD), CVD, and ALD; and a printing method, such as dip coating, inkjet printing, and nanoimprinting.

The average thickness of the n-type semiconductor layer is appropriately selected depending on the intended purpose without any limitation, but the average thickness thereof is preferably 50 nm to 2,000 nm.

It is preferred that an excellent electrical connection be established between the p-type semiconductor layer and the n-type semiconductor layer. In the case where a conventional p-type oxide containing Cu is used as a p-type semiconductor layer of a p-n junction diode, an excellent electric connection may not be attained when a mismatch of lattic with the n-type semiconductor layer occurs, since the orbital constituting the valence band peak (hybrid orbital of a 3d orbital of Cu and a 2p orbital of O) is anisotropic. On the other hand, in the case where the p-type oxide semiconductor of the present invention is used as a p-type semiconductor layer, an influence of the aforementioned lattice mismatch is hardly received, as the valence band peak is composed of a 6s orbital of Tl⁺, which is isotropic and has a large orbital radius. Therefore, an excellent electrical connection state is easily realized. Especially when an n-type semiconductor layer consists of an n-type oxide (e.g., IGZO, In₂O₃, and SnO₂) having an s orbital of a cation, such as In and Sn, at the bottom end of the conduction band, it is preferable to use the p-type oxide of the present invention as a p-type semiconductor layer since isotropic s orbitals are used for transporting carriers in the both n-type and p-type semiconductor layers in that case and excellent electrical connection can be established.

### --Anode (Positive Electrode)--

The anode is in contact with the p-type semiconductor layer.

A material of the anode is appropriately selected depending on the intended purpose without any limitation, and examples thereof include: metal, such as Mo, Al, Au, Ag, and Cu; an alloy of any of the aforementioned metals; transparent conductive oxides, such as indium tin oxide (ITO), and antimony-doped tin oxide; and organic conductors, such as polyethylene dioxythiophene (PEDOT), and polyaniline (PANI).

A shape, size, and structure of the anode are appropriately selected depending on the intended purpose without any limitation.

The anode is provided in contact with the p-type semiconductor layer. It is preferred that the anode and the p-type semiconductor layer form an ohmic contact.

A formation method of the anode is appropriately selected depending on the intended purpose without any limitation, and examples thereof include: (i) a method where after forming a film through sputtering or dip coating, the film is patterned by photolithography; and (ii) a method where a film of a desired shape is directly formed by a printing process, such as inkjet printing, nanoimprinting, and gravure printing.

### --Cathode (Negative Electrode)--

A material of the cathode is appropriately selected depending on the intended purpose without any limitation, and examples thereof include those listed as the material of the anode in the descriptions of the anode.

A shape, size, and structure of the cathode are appropriately selected depending on the intended purpose without any limitation.

The cathode is provided in contact with the n-type semiconductor layer. It is preferred that the cathode and the n-type semiconductor layer form an ohmic contact.

A formation method of the cathode is appropriately selected depending on the intended purpose without any limitation, and examples thereof include those methods listed as the formation method in the descriptions of the anode.

### --Production Method of P-N Junction Diode--

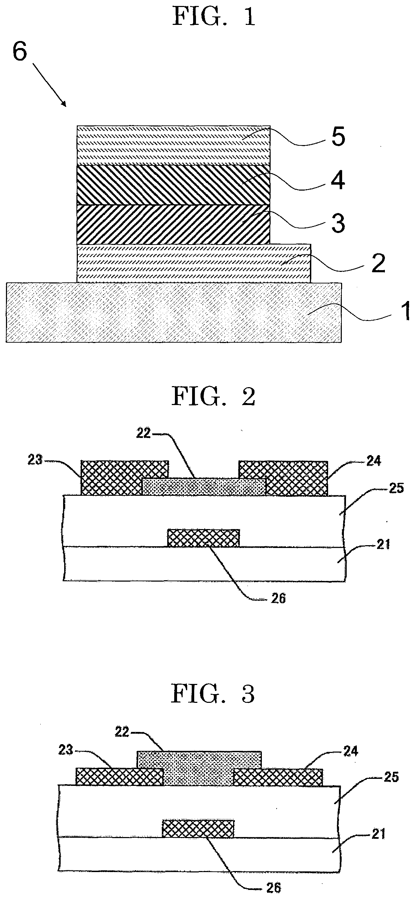

One example of a production method of the p-n junction diode illustrated in FIG. 1 is explained.

First, a cathode 2 is formed on a base material 1.

A shape, structure, and size of the base material are appropriately selected depending on the intended purpose without any limitation.

A base material is appropriately selected depending on the intended purpose without any limitation, and examples thereof include a glass substrate, and a plastic substrate.

A material of the glass substrate is appropriately selected depending on the intended purpose without any limitation, and examples thereof include non-alkali glass, and silica glass.

A material of the plastic substrate is appropriately selected depending on the intended purpose without any limitation, and examples thereof include polycarbonate (PC), polyimide (PI), polyethylene terephthalate (PET), and polyethylene naphthalate (PEN).

Note that, the base material is preferably subjected to a pretreatment, such as oxygen plasma cleaning, UV ozone cleaning, and UV radiation washing, in order to clean a surface thereof, and improve adhesion.

Subsequently, an n-type semiconductor layer 3 is formed on the cathode 2.

Subsequently, a p-type semiconductor layer 4 is formed on the n-type semiconductor layer 3.

Subsequently, an anode 5 is formed on the p-type semiconductor layer 4.

In the manner as described above, the p-n junction diode 6 is produced.

### <Field-Effect Transistor>

The field-effect transistor contains at least a gate electrode, a source electrode, a drain electrode, an active layer, and a gate insulating layer, and may further contain other members according to the necessity.

### -Gate Electrode-

The gate electrode is appropriately selected depending on the intended purpose without any limitation, provided that it is an electrode configured to apply gate voltage.

A material of the gate electrode is appropriately selected depending on the intended purpose without any limitation, and examples thereof include: a metal, such as Mo, Al, Au, Ag, and Cu; an alloy of any of the aforementioned metals; transparent conductive oxides, such as indium tin oxide (ITO), and antimony-doped tin oxide (ATO); and organic conductors, such as polyethylene dioxythiophene (PEDOT), and polyaniline (PANI).

A formation method of the gate electrode is appropriately selected depending on the intended purpose without any limitation, and examples thereof include: (i) a method where after forming a film through sputtering or dip coating, the film is patterned by photolithography; and (ii) a method where a film of a desired shape is directly formed by a printing process, such as inkjet printing, nanoimprinting, and gravure printing.

The average thickness of the gate electrode is appropriately selected depending on the intended purpose without any limitation, but the average thickness thereof is preferably 20 nm to 1 µm, more preferably 50 nm to 300 nm.

### -Source Electrode and Drain Electrode-

The source electrode and the drain electrode are appropriately selected depending on the intended purpose without any limitation, provided that they are electrodes configured to take electric currents out from the field-effect transistor.

A material of the source electrode and drain electrode is appropriately selected depending on the intended purpose without any limitation, and examples thereof include those materials listed in the descriptions of the gate electrode.

When the contact resistance is large between the active layer and the source electrode, and between the active layer and the drain electrode, properties of a transistor may be deteriorated. In order to avoid the deteriorations, it is preferred that a material that will give a small contact resistance be selected as the source electrode and the drain electrode. Specifically, it is preferred that a material having a larger work function than that of the p-type oxide semiconductor of the present invention contained in the active layer be selected.

A formation method of the source electrode, and the drain electrode is appropriately selected depending on the intended purpose without any limitation, and examples thereof include those listed as the formation method in the descriptions of the gate electrode.

The average thickness of the source electrode and the drain electrode is appropriately selected depending on the intended purpose without any limitation, but the average thickness thereof is preferably 20 nm to 1 µm, more preferably 50 nm to 300 nm.

### -Active Layer-

The active layer contains the p-type oxide semiconductor of the present invention.

The active layer is formed between the source electrode and the drain electrode. Here, the "between" is a position where the active layer can operate the field-effect transistor together with the source electrode and the drain electrode. The position of the active layer is appropriately selected depending on the intended purpose without any limitation, as long as it is the aforementioned position.

The composition or formation conditions of the p-type oxide semiconductor is preferably selected in a manner that the carrier density and carrier mobility required to function as the active layer are attained.

The average thickness of the active layer is appropriately selected depending on the intended purpose without any limitation, but the average thickness thereof is preferably 5 nm to 1 µm, more preferably 10 nm to 300 nm.

### -Gate Insulating Layer-

The gate insulating layer is appropriately selected depending on the intended purpose without any limitation, provided that it is an insulating layer formed between the gate electrode and the active layer.

A material of the gate insulating layer is appropriately selected depending on the intended purpose without any limitation, and examples thereof include: materials that have been widely used in mass production, such as SiO₂, and SiNx; high dielectric constant materials, such as La₂O₃, and HfO₂; and organic materials, such as polyimide (PI), and a fluororesin.

A formation method of the gate insulating layer is appropriately selected depending on the intended purpose without any limitation, and examples thereof include: a vacuum film formation method, such as sputtering, chemical vapor deposition (CVD), and atomic layer deposition (ALD); and a printing method, such as spin coating, die coating, and inkjet printing.

The average thickness of the gate insulating layer is appropriately selected depending on the intended purpose without any limitation, but the average thickness thereof is preferably 50 nm to 3 µm, more preferably 100 nm to 1 µm.

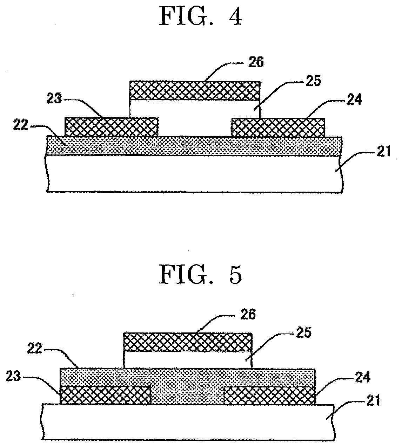

A structure of the field-effect transistor is appropriately selected depending on the intended purpose without any limitation, and examples thereof include a top contact/bottom gate structure (FIG. 2), a bottom contact/ bottom gate structure (FIG. 3), a top contact/ top gate structure (FIG. 4), and a bottom contact/ top gate structure (FIG. 5).

Note that, in FIGs. 2 to 5, 21 is a substrate, 22 is an active layer, 23 is a source electrode, 24 is a drain electrode, 25 is a gate insulating layer, and 26 is a gate electrode.

The field-effect transistor is suitably used for a display element, which is described later, but use thereof is not limited to the display element. For example, the field-effect transistor is suitably used for an IC card, or an ID tag.

Since the field-effect transistor uses the p-type oxide semiconductor of the present invention in an active layer thereof, the active layer of preferable properties is realized, and the transistor characteristics thereof are stable and excellent.

### -Production Method of Field-Effect Transistor-

One example of a production method of the field-effect transistor is explained.

First, a gate electrode is formed on a substrate.

A shape, structure, and size of the substrate are appropriately selected depending on the intended purpose without any limitation.

A material of the substrate is appropriately selected depending on the intended purpose without any limitation, and examples thereof include a glass substrate, and a plastic substrate.

A material of the glass substrate is appropriately selected depending on the intended purpose without any limitation, and examples thereof include non-alkali glass, and silica glass.

A material of the plastic substrate is appropriately selected depending on the intended purpose without any limitation, and examples thereof include polycarbonate (PC), polyimide (PI), polyethylene terephthalate (PET), and polyethylene naphthalate (PEN).

Note that, the substrate is preferably subjected to a pretreatment, such as oxygen plasma cleaning, UV ozone cleaning, and UV radiation washing, in order to clean a surface thereof, and improve adhesion.

Subsequently, the gate insulating layer is formed on the gate electrode.

Subsequently, an active layer containing the p-type oxide semiconductor is formed at the area that is in a channel region, and on the gate insulating layer.

Subsequently, a source electrode and a drain electrode are formed separately from each other on the gate insulating layer in a manner that the source electrode and the drain electrode step over the active layer.

In the manner as described above, a field-effect transistor is produced. In accordance with this production method, a top contact/ bottom gate field-effect transistor, for example, as illustrated in FIG. 2, is produced.

### (Display Element)

The display element of the present invention contains at least a light control element, and a driving circuit configured to drive the light control element, and may further contain other members, according to the necessity.

### <Light Control Element>

The light control element is appropriately selected depending on the intended purpose without any limitation, provided that it is an element configured to control light outlet according to a driving signal. Examples thereof include an organic electroluminescent (EL) element, an electrochromic (EC) element, a liquid crystal element, an electrophoretic element, and an electrowetting element.

### <Driving Circuit>

The driving circuit is appropriately selected depending on the intended purpose without any limitation, provided that the driving circuit contains the semiconductor element of the present invention.

### <Other Members>

Other members are appropriately selected depending on the intended purpose without any limitation.

Since the display element of the present invention contains the semiconductor element (e.g., the field-effect transistor) of the present invention, the display element operates stably. Even when the properties of the light control elements change with time, a driving transistor can be operated at constant gate electrode, which leads to a long service life of the display element.

### (Image Display Device)

The image display device of the present invention contains at least a plurality of display elements, a plurality of lines, and a display control device, and may further contain other members according to the necessity.

### <Display Elements>

The display elements are appropriately selected depending on the intended purpose without any limitation, provided that they are the display elements of the present invention, which are arranged in a matrix.

### <Lines>

The lines are appropriately selected depending on the intended purpose without any limitation, provided that they are capable of separately applying gate voltage and an image data signal to each of field-effect transistors in each of the display elements.

### <Display Control Device>

The display control device is appropriately selected depending on the intended purpose without any limitation, provided that it is capable of controlling the gate voltage and the signal voltage of each of the field-effect transistors through the lines according to the image data.

### <Other Members>

Other members are appropriately selected depending on the intended purpose without any limitation.

Since the image display device of the present invention contains the display element of the present invention, the image display device operates stably with long service life.

The image display device of the present invention can be used as a display unit in a mobile information device (e.g., a mobile phone, a portable music player, a portable video player, an electronic book, and a personal digital assistant (PDA), or a camera device (e.g., a still camera, and a video camera). Moreover, the image display device can also be used as a display unit for various types of information in a transport system, such as a car, an air craft, a train, and a ship. Furthermore, the image display device can be used as a display unit for various types of information in a measuring device, an analysis device, medical equipment, or advertising media.

### (System)

The system of the present invention contains at least the image display device of the present invention, and an image data generating device.

The image data generating device is configured to generate image data based on image information to be displayed, and to output the image data to the image display device.

Since the system of the present invention contains the image display device of the present invention, the system can display image information stably with high performance.

The image display device of the present invention is explained next.

As for the image display device of the present invention, for example, the structure disclosed in the paragraphs [0059] to [0060], and FIGs. 2 and 3 of JP-A No. 2010-074148 can be used.

One example of the embodiments of the present invention is explained with reference to drawings hereinafter.

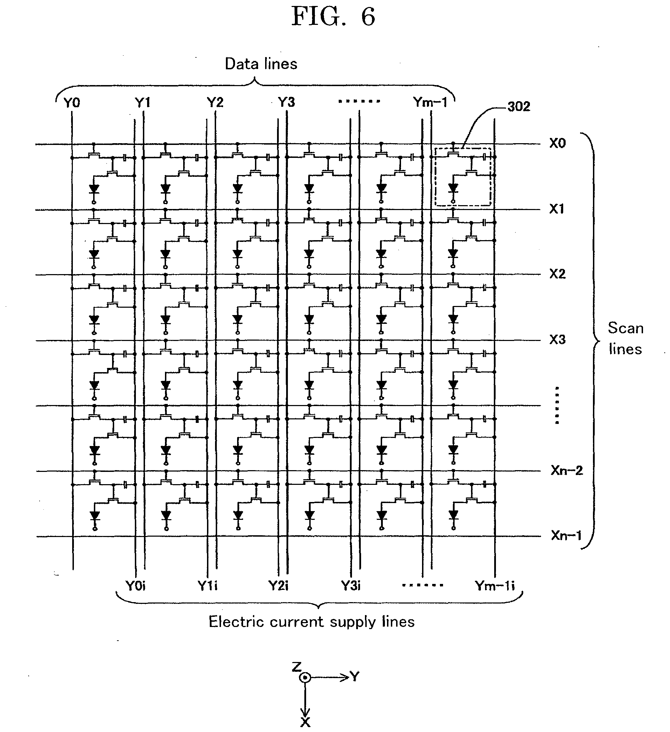

FIG. 6 is a diagram illustrating a display where display elements are arranged in a matrix. As illustrated in FIG. 6, the display contains "n" number of scanning lines (X0, X1, X2, X3, ... Xn-2, Xn-1) arranged along the X axis direction with a constant interval, "m" number of data lines (Y0, Y1, Y2, Y3, ... Ym-1) arranged along the Y axis direction with a constant interval, and "m" number of current supply lines (Y0i, Y1i, Y2i, Y3i, ...Ym-li) arranged along the Y axis direction with a constant interval. Note that, in FIGs. 7, 11, 12, and 13, the same reference number (e.g., X1, Y1) represents the same manner.

Accordingly, the display element 302 can be specified with the scanning line and the data line.

FIG. 7 is a schematic diagram illustrating one example of the display element of the present invention.

As illustrated as one example in FIG. 7, the display element contains an organic electroluminescent (EL) element 350, and a driving circuit 320 configured to induce emission of the organic EL element 350. Specifically, the display 310 is a so-called active matrix organic EL display. Moreover, the display 310 is a 32-inch color display. Note that, a size of the display is not limited to the aforementioned size.

The driving circuit 320 of FIG. 7 is explained.

The driving circuit 320 contains two field-effect transistors 10 and 20, and a capacitor 30.

The field-effect transistor 10 functions as a switching element. The gate electrode G of the field-effect transistor 10 is connected to the predetermined scanning line, and the source electrode S of the field-effect transistor 10 is connected to the predetermined data line. Moreover, the drain electrode D of the field-effect transistor 10 is connected to one of the two terminals of the capacitor 30.

The field-effect transistor 20 is configured to supply electric current to the organic EL element 350. The gate electrode G of the field-effect transistor 20 is connected to the drain electrode D of the field-effect transistor 10. The drain electrode D of the field-effect transistor 20 is connected to the anode of the organic EL element 350, and the source electrode D of the field-effect transistor 20 is connected to the predetermined electric current supply line.

The capacitor 30 is configured to store a state of the field-effect transistor 10, i.e., data. Another terminal of the capacitor 30 is connected to the predetermined electric current supply line.

As the field-effect transistor 10 is turned in the state of "On," the image data is stored in the capacitor 30 via the signal line Y2. Even after turning the field-effect transistor 10 to the state of "Off," the field-effect transistor 20 is maintained in the state of "On" corresponding to the image data so that the organic EL element 350 is driven.

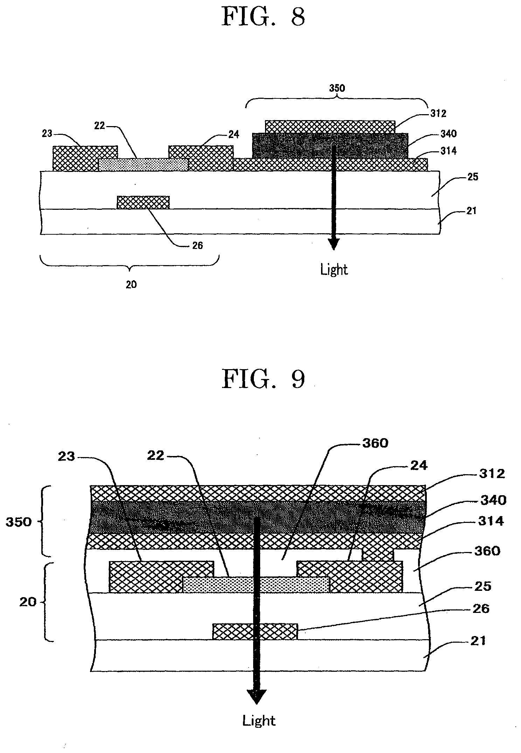

FIG. 8 illustrates one example of a positional relationship between the organic EL element 350 and the field-effect transistor 20 serving as a driving circuit in the display element. In this example, the organic EL element 350 is provided next to the field-effect transistor 20. Note that, the field-effect transistor and a capacitor (not illustrated) are formed on the same substrate.

Although it is not illustrated in FIG. 8, it is also preferred that a protective film be formed on top of the active layer 22. As for a material of the protective film, SiO₂, SiNx, Al₂O₃, or a fluoropolymer is appropriately used.

As illustrated in FIG. 9, for example, the organic EL element 350 may be formed above the field-effect transistor 20. In this case, the gate electrode 26 needs to be transparent. As for the gate electrode 26, therefore, transparent conductive oxides, such as ITO, In₂O₃, SnO₂, ZnO, Ga-doped ZnO, Al-doped ZnO, and Sb-doped SnO₂, are used. Note that, the reference number 360 represents an interlayer insulating film (a leveling film). As for the interlayer insulating film, polyimide, or an acrylic resin can be used.

In FIGs. 8 and 9, the field-effect transistor 20 contains a substrate 21, an active layer 22, a source electrode 23, a drain electrode 24, a gate insulating layer 25, and a gate electrode 26. The organic EL element 350 contains a cathode 312, an anode 314, and an organic EL thin film layer 340.

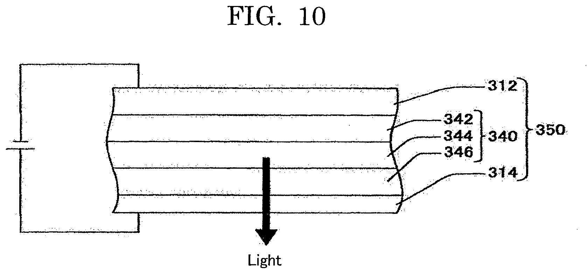

FIG. 10 is a schematic diagram illustrating one example of the organic EL element.

In FIG. 10, the organic EL element 350 contains a cathode 312, an anode 314, and an organic EL thin film layer 340.

A material of the cathode 312 is appropriately selected depending on the intended purpose without any limitation, and examples thereof include aluminum (Al), magnesium (Mg)-silver (Ag) alloy, aluminum (Al)-lithium (Li) alloy, and indium tin oxide (ITO). Note that, the magnesium (Mg)-silver (Ag) alloy films with a sufficient thickness forms a high reflectance electrode, and an extremely thin film (less than about 20 nm) thereof forms a semi-transparent electrode. In FIG. 10, light is taken out from the side of the anode. However, light can be taken out from the side of the cathode by making the cathode a transparent or semi-transparent.

A material of the anode 314 is appropriately selected depending on the intended purpose without any limitation, and examples thereof include indium tin oxide (ITO), indium zinc oxide (IZO), and silver (Ag)-neodymium (Nd) alloy. Note that, in the case where the silver alloy is used, a resulting electrode becomes a high reflectance electrode, which is suitable for taking light out from the side of the cathode.

The organic EL thin film layer 340 contains an electron transporting layer 342, a light emitting layer 344, and a hole transporting layer 346. The electron transporting layer 342 is connected to the cathode 312, and the hole transporting layer 346 is connected to the anode 314. As the predetermined voltage is applied between the anode 314 and the cathode 312, the light emitting layer 344 emits light.

Here, the electron transporting layer 342 and the light emitting layer 344 may form one layer. Moreover, an electron injecting layer may be provided between the electron transporting layer 342 and the cathode 312. Furthermore, a hole injecting layer may be provided between the hole transporting layer 346 and the anode 314.

As for the light control element, the so-called "bottom emission" organic EL element, in which light is taken out from the side of the substrate (bottom side in FIG. 10), is explained above. However, the light control element may be a "top emission" organic EL element, in which light is taken out from the opposite side to the substrate side.

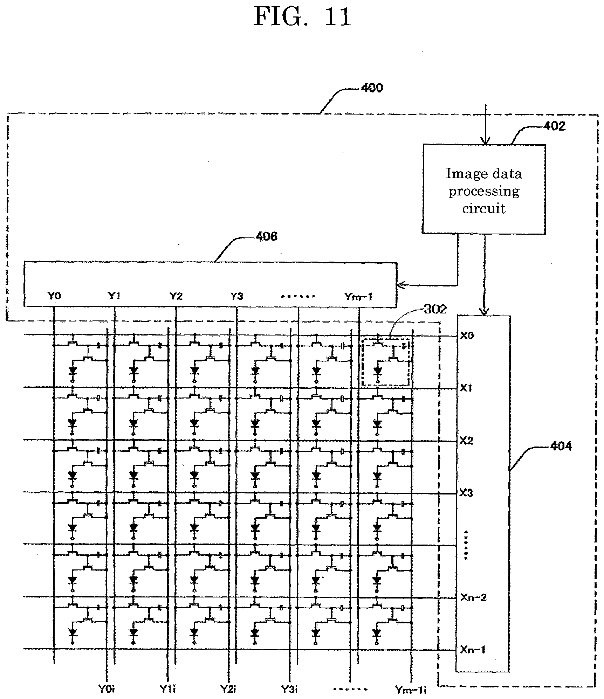

FIG. 11 is a schematic diagram illustrating another example of the image display device of the present invention.

In FIG. 11, the image display device contains a display element 302, lines (scanning lines, data lines, and electric current supply lines), and a display control device 400.

The display control device 400 contains an image data processing circuit 402, a scanning line driving circuit 404, and a data line driving circuit 406.

The image data processing circuit 402 judges luminance of a plurality of the display elements 302 based on output signal of the image output circuit.

The scanning line driving circuit 404 individually applies voltage to the number "n" of scanning lines according to the instructions of the image data processing circuit 402.

The data line driving circuit 406 individually applies voltage to the number "m" of data lines according to the instruction of the image data processing circuit 402.

The embodiment above explains the case where the light control element is an organic EL element, but the light control element is not limited to the organic EL element. For example, the light control element may be an electrochromic element. In this case, the display is an electrochromic display.

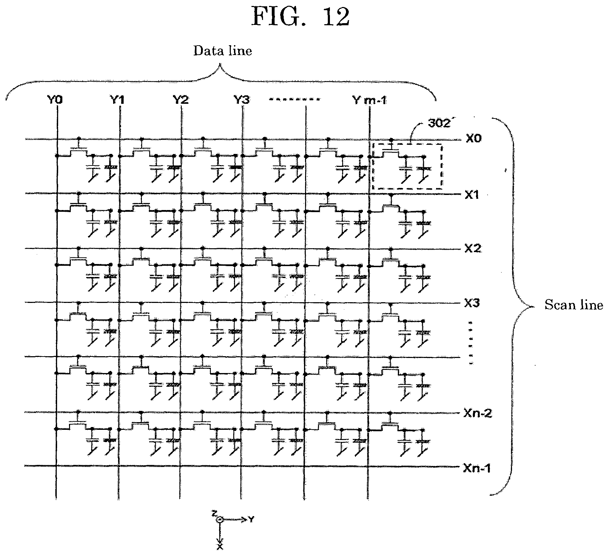

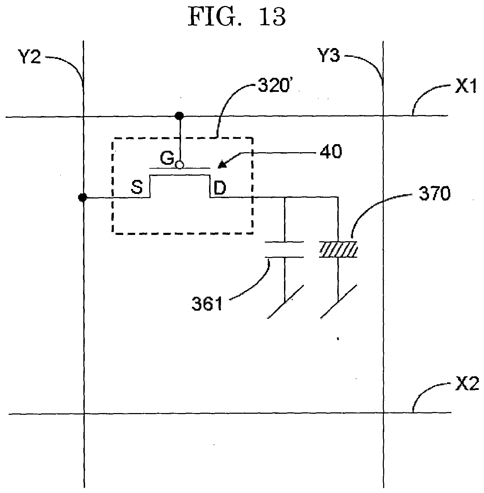

Moreover, the light control element may be a liquid crystal element. In this case, the display is a liquid crystal display, and a current supply line is not necessary to the display element 302' as illustrated in FIG. 12. As illustrated in FIG. 13, moreover, the driving circuit 320' may be composed of one field-effect transistor 40, which is identical to the field-effect transistors 10 and 20. In the field-effect transistor 40, the gate electrode G is connected to the predetermined scanning line, and the source electrode S is connected to the predetermined data line. Moreover, the drain electrode D is connected to the capacitor 361 and a pixel electrode of the liquid crystal element 370.

Moreover, the light control element may be an electrophoretic element, an inorganic EL element, or an electrowetting element.

The case where the system of the present invention is a television device is explained above, but the system is not limited as long as the system contains the image display device as a device for displaying images and information. For example, the system may be a computer system, in which a computer (including a personal computer) is connected to the image display device.

Since the system of the present invention contains the image display device of the present invention, the system operates stably with a long-service life.

### Examples

Examples of the present invention are explained hereinafter, but the examples shall not be construed as to limit a scope of the present invention.

### (Examples 1 to 15)

### <Production of T1-Containing Oxide Semiconductor Film>

Thallium 2-ethylhexanoate (695.2 mg) was dissolved in 2 mL of toluene, to thereby obtain a thallium compound solution A. The molar concentration of the thallium (Tl) in the thallium compound solution A was 1 M.

By adding 0.173 mL of a toluene solution of magnesium 2-ethylhexanoate, which was a 3.0% by mass magnesium (equivalent to 1.158 M) solution, to 1.827 mL of toluene, a magnesium compound solution B was obtained. The molar concentration of the magnesium (Mg) in the magnesium compound solution B was 0.1 M.

By adding 0.495 mL of a toluene solution of zinc 2-ethylhexanoate, which was a 3.0% by mass zinc (equivalent to 0.404 M) solution, to 1.505 mL of toluene, a zinc compound solution C was obtained. The molar concentration of the zinc (Zn) in the zinc compound solution C was 0.1 M.

Hexamethyl disilazane (0.104 mL) was diluted with 9.896 mL of toluene, to thereby obtain a silicon compound solution D. The molar concentration of the silicon (Si) in the silicon compound solution D was 0.1 M.

Phenylboronic acid pinacol ester (204.1 mg) was dissolved in 2 mL of toluene, to thereby obtain a boron compound solution E. The molar concentration of the boron (B) in the boron compound solution E was 0.5 M.

Tellurium (IV) isopropoxide (0.364 mL) was diluted with 10 mL of toluene, to thereby obtain a tellurium compound solution F. The molar concentration of tellurium (Te) in the tellurium compound solution F was 0.1 M.

Gallium acetylacetonate (183.5 mg) was dissolved in 2 mL of toluene, to thereby obtain a gallium compound solution G. The molar concentration of the gallium (Ga) in the gallium compound solution G was 0.25 M.

Aluminum acetylacetonate (162.2 mg) was dissolved in 2 mL of toluene, to thereby obtain an aluminum compound solution H. The molar concentration of the aluminum (Al) in the aluminum compound solution H was 0.25 M.

Tin 2-ethylhexanoate (0.341 mL) having the purity of 95% by mass and 1.659 mL of toluene were blended, to thereby obtain a tin compound solution I. The molar concentration of the tin (Sn) of the tin compound solution I was 0.5 M.

Triphenylantimony (353.1 mg) was dissolved in 2 mL of toluene, to thereby obtain an antimony compound solution J. The molar concentration of the antimony (Sb) of the antimony compound solution J was 0.5 M.

Lead 2-ethylhexanoate (0.333 mL) and 1.667 mL of toluene were blended, to thereby obtain a lead compound solution K. The molar concentration of the lead (Pb) in the lead compound solution K was 0.5 M.

By adding 0.968 mL of a xylene solution of bismuth 2-ethylhexanoate, which was a 24% by mass bismuth (equivalent to 1.033 M) solution, to 0.968 mL of toluene, a bismuth compound solution L was obtained. The molar concentration of the bismuth (Bi) of the bismuth compound solution L was 0.5 M.

Using these solutions, 15 types of inks (compositions for producing a p-type oxide semiconductor) having formulations depicted in Table 1 were prepared.

Subsequently, each of the 15 inks was spin coated onto a glass substrate. After drying the ink at 120°C for 1 hour, the ink was baked at 250°C for 3 hours while applying light with an excimer lamp (wavelength: 222 nm) under a nitrogen flow having the oxygen concentration of 0.1 ppm to 0.3 ppm, to thereby form Tl-containing oxide films (p-type oxide semiconductor film) of the 15 formulations.

**Table 1**

| | Ink | Ink formulation | | | |
|---|---|---|---|---|---|
| | | Molar ratio of metal element | Toluene [mL] | Thallium compound solution A [mL] | Metal compound solution other than thallium |
| Ex. 1 | 1 | Tl only | 1 | 1 | None |
| Ex. 2 | 2 | Tl:Mg=1:0.1 | 0 | 1 | Magnesium compound solution B (1 mL) |
| Ex. 3 | 3 | Tl:Zn=1:0.1 | 0 | 1 | Zinc compound solution C (1 mL) |
| Ex. 4 | 4 | Tl:Si=1:0.2 | 0 | 1 | Silicon compound solution D (2 mL) |
| Ex. 5 | 5 | Tl:B=1:0.05 | 1 | 1 | Boron compound solution E (0.1 mL) |
| Ex. 6 | 6 | Tl:Te=1:0.05 | 0.5 | 1 | Tellurium compound solution F (0.5 mL) |
| Ex. 7 | 7 | Tl:Ga=1:1 | 0 | 0.5 | Gallium compound solution G (2 mL) |
| Ex. 8 | 8 | Tl:Al=1:1 | 0 | 0.5 | Aluminum compound solution H (2 mL) |
| Ex. 9 | 9 | Tl:Ga:Al=1:0.5:0.5 | 0 | 0.5 | Gallium compound solution G (1 mL)/aluminum compound solution H (1 mL) |
| Ex. 10 | 10 | Tl:Al=2:1 | 0.5 | 0.5 | Aluminum compound solution H (1 mL) |
| Ex. 11 | 11 | Tl:Al:Mg=1:0.99:0.01 | 0 | 0.5 | Aluminum compound solution H (1.98 mL)/ magnesium compound solution B (0.05 mL) |
| Ex. 12 | 12 | Tl:Sn=1:1 | 1 | 1 | Tin compound solution I (2 mL) |
| Ex. 13 | 13 | Tl:Sb=1:0.4 | 1 | 1 | Antimony compound solution J (0.8 mL) |
| Ex. 14 | 14 | Tl:Pb=1:0.5 | 1 | 1 | Lead compound solution K (1 mL) |
| Ex. 15 | 15 | Tl:Bi=1:0.5 | 1 | 1 | Bismuth compound solution L (1 mL) |

### (Comparative Example 1)

By adding 0.767 mL of a toluene solution of 8.28% by mass copper neodecanoate (equivalent to 1.30 M) to 1.233 mL of toluene, an ink for Cu oxide was obtained. Similarly to Example 1, the ink for Cu oxide was applied onto a glass substrate by spin coating, followed by drying the ink at 120°C for 1 hour. Thereafter, the ink was baked at 250°C for 3 hours while applying light to the ink with an excimer lamp (wavelength: 222 nm) under a flow of nitrogen.

### <Measurement of Film Thickness>

A reflection spectrum (wavelength: about 300 nm to about 700 nm) of each of the oxide films obtained in Examples 1 to 15 and Comparative Example 1 was analyzed using a reflective film thickness monitor (FE-3000, manufactured by Otsuka Electronics Co., Ltd.), to thereby determine a film thickness of the oxide film. The results are presented in Table 2.

### <X-Ray Diffraction>

Each of the oxide films of Examples 1 to 15 and Comparative Example 1 was subjected to X-ray diffraction spectroscopy by means of X'PertPro (manufactured by Philips).

In the x-ray diffraction spectroscopy performed on the p-type oxide semiconductors of Examples 1 to 6, the strongest peak appeared at 2θ of about 29 degrees, and the second strongest peak appeared between about 32 degrees and about 34 degrees. These peak positions correspond to a known crystal structure (rhombohedral system, space group: R-3m) of Tl₂O.

In the x-ray diffraction spectroscopy performed on the p-type oxide semiconductors of Examples 7 to 9, and 11, the two strongest peaks appeared at about 31 degrees and at about 33 degrees, respectively. This result corresponds to known crystal structures (rhombohedral system, space group: R-3m) of TlAlO₂ and TlGaO₂.

In the x-ray diffraction spectroscopy performed on the p-type oxide semiconductors of Examples 10, and 12 to 15, a diffraction peak was not observed, and it was found that these films were amorphous.

In the x-ray diffraction spectroscopy performed on the Cu oxide of Comparative Example 1, the strongest peak appeared at 2θ of about 36 degrees, and the peaks having the smaller intensities were observed at about 39 degrees, about 42 degrees, and about 61 degrees. The peak at the about 39 degrees corresponds to a CuO crystal, and the peaks at about 42 degrees and about 61 degrees correspond to a Cu₂O crystal. It was considered that the peak at about 36 degrees was observed as peaks from both a CuO crystal and a Cu₂O crystal, without being separated. It was found from the results above that the obtained Cu oxide film was in a polycrystalline state where CuO crystals and Cu₂O crystals were mixed.

### <Hall Measurement

At four corners of each of the oxide films of Examples 1 to 15 and Comparative Example 1, circular Au films were formed by vacuum vapor deposition. These Au films were used as electrode, and Hall measurement was performed by means of ResiTest 8400 (manufactured by TOYO Corporation). The results of the volume resistivity, carrier density, and n-type/p-type judgment are presented in Table 2.

**Table 2**

| | Molar ratio of metal element | Film thickness [nm] | Volume resistivity [Ωcm] | Carrier density [/cm³] | n-type/ type judgment |
|---|---|---|---|---|---|
| Ex. 1 | Tl only | 61 | 3.78× 10⁰ | 5.90×10¹⁶ | p |
| Ex. 2 | Tl:Mg=1:0.1 | 63 | 9.63×10⁰ | 5.40×10¹⁶ | p |
| Ex. 3 | Tl:Zn=1:0.1 | 64 | 4.95×10¹ | 9.00×10¹⁵ | p |
| Ex. 4 | Tl:Si=1:0.2 | 52 | 9.63×10¹ | 2.70×10¹⁶ | p |
| Ex. 5 | Tl:B=1:0.05 | 62 | 8.39×10⁰ | 3.10×10¹⁶ | p |
| Ex. 6 | Tl:Te=1:0.05 | 62 | 9.66×10⁰ | 3.40×10¹⁶ | p |
| Ex. 7 | Tl:Ga=1:1 | 50 | 8.49×10⁻¹ | 2.10×10¹⁷ | p |
| Ex. 8 | T1:Al=1:1 | 52 | 2.30×10⁻¹ | 5.90×10¹⁷ | p |
| Ex. 9 | Tl:Ga:Al=1:0.5:0.5 | 55 | 5.12×10⁻¹ | 3.05×10¹⁷ | p |
| Ex. 10 | Tl:Al=2:1 | 47 | 9.18×10⁴ | 8.50×10¹⁴ | p |
| Ex. 11 | Tl:Al:Mg=1:0.99:0.01 | 51 | 1.03×10⁻¹ | 1.32×10¹⁸ | p |
| Ex. 12 | Tl:Sn=1:1 | 61 | 6.45×10³ | 1.21×10¹⁵ | p |
| Ex. 13 | Tl:Sb=1:0.4 | 55 | 2.85×10² | 8.75×10¹⁵ | p |
| Ex. 14 | Tl:Pb=1:0.5 | 55 | 9.30×10² | 6.10×10¹⁵ | p |
| Ex. 15 | Tl:Bi=1:0.5 | 60 | 5.78×10² | 1.80×10¹⁶ | p |
| Comp. Ex. 1 | Cu only | 62 | 3.60×10⁸ | Could not be measured | Cannot be judged |

Considering the results of the X-ray diffraction and the Hall measurement in combination, obtained were crystal films of Tl₂O in Examples 1 to 6, TlGaO₂ in Example 7, TlAlO₂ in Examples 8 and 11, and Tl(Al_{0.5}Ga_{0.5})O₂ in Example 9, provided that the oxygen content was excessive in terms of a difference from stoichiometry. The Tl in each film was in the monovalent state. The electric properties thereof were p-type using holes as carriers. The films of Examples 10, and 12 to 15 were amorphous, and information regarding a valency of Tl could not be attained from the structures thereof, but it was confirmed from the results of the Hall measurements that these films had p-type conductivity properties.

It could be confirmed in all Examples that holes were present in the film with a sufficient density. It was assumed that holes were generated by oxygen excess nonstoichiometry in Examples 1 to 10, and 12 to 15. The generation of holes was achieved by selecting appropriate metal compound contained in the composition, and optimizing various parameter of the drying and baking step after applying the composition onto the substrate. The conductivity properties were controlled in the range of 0.230 Qcm to 9.18×10⁴ Qcm by varying the ratio of the metal elements contained in the oxide film. In Example 11, 1% of the Al sites of the TlAlO₂ crystal was substituted with Mg. Holes were generated by the substitutional doping in addition to oxygen excess nonstoichiometry, and as a result, the highest hole density was obtained among all Examples.

Specifically, in all Examples, holes were present in the film with a sufficient density, which was realized by hole doping, and the high mobility was attained by constituting the valence band peak with a 6s orbital of monovalent Tl, and therefore useful p-type conductivity properties were realized.

In Comparative Example 1, on the other hand, the obtained film was a polycrystalline film, in which a CuO crystal and a Cu₂O crystal were mixed, as seen from the result of X-ray diffraction. The measurement of the carrier density or judgment of conductivity could not be performed, as the resistivity was too high. When the volume resistivity of the active layer in the semiconductor element was greater than 10⁸ Ωcm, it is difficult to attain ohmic contact with an electrode conntected to the semiconductor. The film of Comparative Example 1 was therefore not suitable for applicable use as an active layer.

Accordingly, the oxide film of the present invention, which contained Tl and had been hole doped, could attain the predetermined p-type conductivity. However, the conventional Cu oxide film could not attain useful p-type conductivity properties, as two valence stages Cu were present together.

### (Example 16)

### <Production of Field-Effect Transistor>

### -Preparation of Base Material (Gate Electrode, Gate Insulating Layer)-

As for a base material, a Si substrate with a thermally oxidized film (thickness: 200 nm) was used. The Si substrate was subjected to ultrasonic wave washing using a neutral detergent, pure water, and isopropyl alcohol. After drying, the substrate was further subjected to a UV-ozone treatment at 90°C for 10 minutes. Note that, the thermally oxidized film served as a gate insulating layer, and the Si substrate served as a gate electrode.

### -Formation of Source Electrode and Drain Electrode-

On the thermally oxidized film, Cr was deposited by 1 nm, and then Au was deposited by 50 nm, both by vapor deposition. Thereafter, a photoresist was applied thereon, and the applied photoresist was subjected to prebaking, exposure by an exposure device, and developing, to thereby form a resist pattern having the same pattern to that of electrodes to be formed. Moreover, par of the Cr/Au film, on which the resist pattern had not been formed, was removed, followed by removing the resist pattern, to thereby form a source electrode and a drain electrode. The channel length was 10 µm, and the channel width was 30 µm.

### -Preparation of Semiconductor Ink for Inkjet Printing-

Thallium nitrate trihydrate (4.44 g)(equivalent to 10 mmol) was dissolved in 10 mL of 2-methoxy ethanol, to thereby produce a Tl compound solution M. Moreover, 3.75 g (equivalent to 10 mmol) of aluminum nitrate nonahydrate was dissolved in 10 mL of 2-methoxy ethanol, to thereby obtain an Al compound solution N.

Propylene glycol (4 mL), 2-methoxy ethanol (2 mL), the Tl compound solution M (1 mL), and the Al compound solution N (1 mL) were mixed and stirred, to thereby prepare a semiconductor ink for inoket printing (TlAl ink O). The molar ratio of Tl and Al in the ink was 1:1.

### -Formation of Active Layer-

The TlAl ink O was applied to the predetermined area of the substrate, on which the source electrode and drain electrode had been formed, by means of an inkjet printing. After drying the ink at 120°C for 1 hour, the ink was baked at 250°C for 3 hours, while applying light with an excimer lamp (wavelength: 222 nm), to thereby form a TlAl oxide film having a thickness of 30 nm. As a result of this, a structure of a field-effect transistor was completed.

### (Example 17)

### <Production of Field-Effect Transistor>

A field-effect transistor was produced in the same manner as in Example 16, provided that the semiconductor ink was replaced with the following semiconductor ink (TlSb ink R).

### -Preparation of Semiconductor Ink for Inkjet Printing-

Thallium formate (2.49 g)(equivalent to 10 mmol) was dissolved in 10 mL of dimethyl amino ethanol, to thereby obtain a thallium compound solution P. Moreover, 3.53 g (equivalent to 10 mmol) of triphenylantimony was dissolved in 10 mL of dimethyl amino ethanol, to thereby obtain an antimony compound solution Q.

Propylene glycol (3 mL), dimethyl amino ethanol (3 mL), the thallium compound solution P (1 mL), and the antimony compound solution Q (1 mL) were mixed and stirred, to thereby prepare a semiconductor ink for inkjet printing (TISb ink R). The molar ratio of Tl and Sb in the ink was 1:1.

### <Evaluation>

The transfer properties (Vds = -10 V) of the field-effect transistors produced in Examples 16 and 17 were measured, and excellent normally-off p-type transistor properties were exhibited. Note that, the mobility of the field-effect transistor of Example 16 was larger than that of the field-effect transistor of Example 17. The field-effect transistor of Example 17 had larger Vth (threshold voltage) compared to that of the transistor of Example 16.

### Reference Signs List

- 2:: cathode
- 3:: n-type semiconductor layer
- 4:: p-type semiconductor layer
- 5:: anode
- 6:: p-n junction diode
- 10:: field-effect transistor
- 20:: field-effect transistor
- 22:: active layer
- 23:: source electrode
- 24:: drain electrode
- 25:: gate insulating layer
- 26:: gate electrode
- 40:: field-effect transistor
- 302, 302':: display element
- 310:: display
- 320, 320':: driving circuit
- 370:: liquid crystal element
- 400:: display control device

## Claims

1. A p-type oxide semiconductor, comprising:
a metal oxide containing thallium (Tl) in a +1 valent state, wherein the metal oxide does not contain a Cu element and the metal oxide contains excess oxygen or the metal oxide contains anions having smaller ionic valency than oxygen.

2. The p-type oxide semiconductor according to claim 1, wherein the metal oxide contains at least one selected from the group consisting of magnesium (Mg), calcium (Ca), strontium (Sr), barium (Ba), zinc (Zn), cadmium (Cd), boron (B), aluminum (Al), gallium (Ga), silicon (Si), germanium (Ge), and tellurium (Te).

3. The p-type oxide semiconductor according to claim 1 or 2, wherein the metal oxide contains at least one selected from the group consisting of tin (Sn), antimony (Sb), lead (Pb), and bismuth (Bi).

4. The p-type oxide semiconductor according to any one of claims 1 to 3, wherein the metal oxide contains aluminum (Al), or gallium (Ga), or both.

5. The p-type oxide semiconductor according to claim 4, wherein an amount by mole of thallium (Tl) contained in the metal oxide is substantially equal to a total amount by mole of aluminum (Al) and gallium (Ga) contained in the metal oxide.

6. A composition for producing a p-type oxide semiconductor, comprising:
a solvent; and
a Tl-containing compound,
wherein the composition is used for production of the p-type oxide semiconductor according to any one of claims 1 to 5.

7. A method for producing a p-type oxide semiconductor, comprising:
applying a composition onto a support; and
performing a heat treatment after the applying,
wherein the p-type oxide semiconductor is the p-type oxide semiconductor according to any one of claims 1 to 5, and
wherein the composition contains a solvent, and a Tl-containing compound.

8. A semiconductor element (10, 20, 40), comprising:
an active layer (22),
wherein the active layer (22) contains the p-type oxide semiconductor according to any one of claims 1 to 5.

9. The semiconductor element (10, 20, 40) according to claim 8, wherein the semiconductor element is a diode, which contains:
a first electrode (23);
a second electrode (24); and
the active layer (22) formed between the first electrode (23) and the second electrode (24).

10. The semiconductor element (10, 20, 40) according to claim 8, wherein the semiconductor element is a field-effect transistor, which contains:
a gate electrode (26);
a source electrode (23) and a drain electrode (24);
the active layer (22) formed between the source electrode (23) and the drain electrode (24); and
a gate insulating layer (25) formed between the gate electrode (26) and the active layer (22).

11. A display element (302, 302'), comprising:
a light control element configured to control light output according to a driving signal; and
a driving circuit (320, 320'), which contains the semiconductor element (10, 20, 40) according to claim 8, and is configured to drive the light control element.

12. The display element (302, 302') according to claim 11, wherein the light control element contains an organic electroluminescent element, an electrochromic element, a liquid crystal element (370), an electrophoretic element, or an electrowetting element.

13. An image display device (310), which displays an image corresponding to image data, and which comprising:
a plurality of the display elements (302, 302') according to claim 11, arranged in a matrix;
a plurality of lines each configured to separately apply gate voltage to field-effect transistors (10, 20, 40) in each of the display elements (302, 302'); and
a display control device (400) configured to individually control the gate voltage of each of field-effect transistors (10, 20, 40) through the lines according to the image data.

14. A system, comprising:
the image display device (310) according to claim 13; and
an image data generating device configured to generate image data based on image information to be displayed, and to output the generated image data to the image display device (310).

## Patentansprüche

1. P-Typ-Oxidhalbleiter, umfassend:
ein Metalloxid, welches Thallium (Tl) in einem +1-wertigen Zustand enthält, wobei das Metalloxid kein Kupferelement enthält und das Metalloxid überschüssigen Sauerstoff enthält oder das Metalloxid Anionen mit einer kleineren Ionenvalenz als Sauerstoff enthält.

2. P-Typ-Oxidhalbleiter nach Anspruch 1, wobei das Metalloxid zumindest eines ausgewählt aus der Gruppe bestehend aus Magnesium (Mg), Calcium (Ca), Strontium (Sr), Barium (Ba), Zink (Zn), Cadmium (Cd), Bor (B), Aluminium (Al), Gallium (Ga), Silizium (Si), Germanium (Ge) und Tellur (Te) enthält.

3. P-Typ-Oxidhalbleiter nach Anspruch 1 oder 2, wobei das Metalloxid zumindest eines ausgewählt aus der Gruppe bestehend aus Zinn (Sn), Antimon (Sb), Blei (Pb) und Wismut (Bi) enthält.

4. P-Typ-Oxidhalbleiter nach einem der Ansprüche 1 bis 3, wobei das Metalloxid Aluminium (Al) oder Gallium (Ga) oder beides enthält.

5. P-Typ-Oxidhalbleiter nach Anspruch 4, wobei eine Molmenge von Thallium (Tl), welches in dem Metalloxid enthalten ist, im Wesentlichen gleich einer insgesamten Molmenge von Aluminium (Al) und Gallium (Ga), welche in dem Metalloxid enthalten ist, ist.

6. Zusammensetzung zur Herstellung eines p-Typ-Oxidhalbleiters, umfassend:
ein Lösungsmittel; und
eine Tl-haltige Verbindung,
wobei die Verbindung zur Herstellung des p-Typ-Oxidhalbleiters nach einem der Ansprüche 1 bis 5 verwendet wird.

7. Verfahren zur Herstellung eines p-Typ-Oxidhalbleiters, umfassend:
Aufbringen einer Zusammensetzung auf einen Träger; und
Durchführung einer Wärmebehandlung nach dem Aufbringen,
wobei der p-Typ-Oxidhalbleiter der p-Typ-Oxidhalbleiter nach einem der Ansprüche 1 bis 5 ist, und
wobei die Zusammensetzung ein Lösungsmittel und eine Tl-haltige Verbindung enthält.

8. Halbleiterelement (10, 20, 40), umfassend:
eine aktive Schicht (22),
wobei die aktive Schicht (22) den p-Typ-Oxidhalbleiter nach einem der Ansprüche 1 bis 5 enthält.

9. Halbleiterelement (10, 20, 40) nach Anspruch 8, wobei das Halbleiterelement eine Diode ist, welche enthält:
eine erste Elektrode (23);
eine zweite Elektrode (24); und
die aktive Schicht (22), welche zwischen der ersten Elektrode (23) und der zweiten Elektrode (24) gebildet ist.

10. Halbleiterelement (10, 20, 40) nach Anspruch 8, wobei das Halbleiterelement ein Feldeffekttransistor ist, welcher enthält:
eine Gate-Elektrode (26);
eine Source-Elektrode (23) und eine Drain-Elektrode (24);
die aktive Schicht (22), welche zwischen der Source-Elektrode (23) und der Drain-Elektrode (24) gebildet ist; und
eine Gate-Isolierschicht (25), welche zwischen der Gate-Elektrode (26) und der aktiven Schicht (22) gebildet ist.

11. Anzeigeelement (302, 302'), umfassend:
ein Lichtsteuerelement, welches ausgestaltet ist, eine Lichtausgabe gemäß einem Ansteuersignal zu steuern; und
eine Ansteuerschaltung (320, 320'), welche das Halbleiterelement (10, 20, 40) gemäß Anspruch 8 enthält, und welche ausgestaltet ist, das Lichtsteuerelement anzusteuern.

12. Anzeigeelement (302, 302') nach Anspruch 11, wobei das Lichtsteuerelement ein organisches Elektrolumineszenzelement, ein elektrochromes Element, ein Flüssigkristallelement (370), ein elektrophoretisches Element oder ein Elektrobenetzungselement enthält.

13. Bildanzeigegerät (310), welches ein Bild korrespondierend zu Bilddaten anzeigt, und welches umfasst:
eine Vielzahl von Anzeigeelementen (302, 302') gemäß Anspruch 11, welche in einer Matrix angeordnet sind;
eine Vielzahl von Leitungen, welche jeweils ausgestaltet sind, separat eine Gate-Spannung an Feldeffekttransistoren (10, 20, 40) in jedem der Displayelemente (302, 302') anzulegen; und
ein Anzeigesteuergerät (400), welches ausgestaltet ist, die Gate-Spannung jedes der Feldeffekttransistoren (10, 20, 40) durch die Leitungen gemäß den Bilddaten einzeln anzusteuern.

14. System, umfassend:
das Bildanzeigegerät (310) nach Anspruch 13; und
ein Bilddatenerzeugungsgerät, welches ausgestaltet ist, Bilddaten basierend auf anzuzeigenden Bildinformationen zu erzeugen, und die erzeugten Bilddaten an das Bildanzeigegerät (310) auszugeben.

## Revendications

1. Semi-conducteur d'oxyde de type p, comprenant :
un oxyde de métal contenant du thallium (Tl) dans un état de valence +1, dans lequel l'oxyde de métal ne contient pas d'élément Cu et l'oxyde de métal contient de l'oxygène en excès ou l'oxyde de métal contient des anions ayant une valence ionique plus petite que l'oxygène.

2. Semi-conducteur d'oxyde de type p selon la revendication 1, dans lequel l'oxyde de métal contient au moins un élément choisi dans le groupe constitué par le magnésium (Mg), le calcium (Ca), le strontium (Sr), le baryum (Ba), le zinc (Zn), le cadmium (Cd), le bore (B), l'aluminium (Al), le gallium (Ga), le silicium (Si), le germanium (Ge), et le tellure (Te).

3. Semi-conducteur d'oxyde de type p selon la revendication 1 ou 2, dans lequel l'oxyde de métal contient au moins un élément choisi dans le groupe constitué par l'étain (Sn), l'antimoine (Sb), le plomb (Pb), et le bismuth (Bi).

4. Semi-conducteur d'oxyde de type p selon l'une quelconque des revendications 1 à 3, dans lequel l'oxyde de métal contient de l'aluminium (Al), ou du gallium (Ga), ou les deux.

5. Semi-conducteur d'oxyde de type p selon la revendication 4, dans lequel une quantité en moles de thallium (Tl) contenu dans l'oxyde de métal est sensiblement égale à une quantité totale en moles d'aluminium (Al) et de gallium (Ga) contenus dans l'oxyde de métal.

6. Composition pour la production d'un semi-conducteur d'oxyde de type p, comprenant :
un solvant ; et
un composé contenant Tl,
dans laquelle la composition est utilisée pour la production du semi-conducteur d'oxyde de type p selon l'une quelconque des revendications 1 à 5.

7. Procédé pour la production d'un semi-conducteur d'oxyde de type p, comprenant :
l'application d'une composition sur un support ; et
la réalisation d'un traitement thermique après l'application,
dans lequel le semi-conducteur d'oxyde de type p est le semi-conducteur d'oxyde de type p selon l'une quelconque des revendications 1 à 5, et
dans lequel la composition contient un solvant, et un composé contenant Tl.

8. Élément à semi-conducteur (10, 20, 40), comprenant :
une couche active (22),
dans lequel la couche active (22) contient le semi-conducteur d'oxyde de type p selon l'une quelconque des revendications 1 à 5.

9. Élément à semi-conducteur (10, 20, 40) selon la revendication 8, dans lequel l'élément à semi-conducteur est une diode, qui contient :
une première électrode (23) ;
une deuxième électrode (24) ; et
la couche active (22) formée entre la première électrode (23) et la deuxième électrode (24).

10. Élément à semi-conducteur (10, 20, 40) selon la revendication 8, dans lequel l'élément à semi-conducteur est un transistor à effet de champ, qui contient :
une électrode grille (26) ;
une électrode source (23) et une électrode drain (24) ;
la couche active (22) formée entre l'électrode source (23) et l'électrode drain (24) ; et
une couche isolante de grille (25) formée entre l'électrode grille (26) et la couche active (22).

11. Élément d'affichage (302, 302'), comprenant :
un élément de commande de lumière configuré pour commander une sortie de lumière selon un signal de pilotage ; et
un circuit de pilotage (320, 320'), qui contient l'élément à semi-conducteur (10, 20, 40) selon la revendication 8, et est configuré pour piloter l'élément de commande de lumière.

12. Élément d'affichage (302, 302') selon la revendication 11, dans lequel l'élément de commande de lumière contient un élément électroluminescent organique, un élément électrochromique, un élément à cristaux liquides (370), un élément électrophorétique, ou un élément électromouillant.

13. Dispositif d'affichage d'image (310), qui affiche une image correspondant à des données d'image et qui comprend :
une pluralité des éléments d'affichage (302, 302') selon la revendication 11, agencés dans une matrice ;
une pluralité de lignes configurées chacune pour appliquer séparément une tension de grille à des transistors à effet de champ (10, 20, 40) dans chacun des éléments d'affichage (302, 302') ; et
un dispositif de commande d'affichage (400) configuré pour commander individuellement la tension de grille de chacun de transistors à effet de champ (10, 20, 40) à travers les lignes selon les données d'image.

14. Système, comprenant :
le dispositif d'affichage d'image (310) selon la revendication 13 ; et
un dispositif de génération de données d'image configuré pour générer des données d'image sur la base d'informations d'image à afficher, et pour fournir en sortie les données d'image générées au dispositif d'affichage d'image (310).
